Europäisches Patentamt

European Patent Office

Office européen des brevets

(11) Publication number: **0 463 745 A1**

# EUROPEAN PATENT APPLICATION

(21) Application number: **91304924.3**

(22) Date of filing: **31.05.91**

(51) Int. Cl.⁵: **H01L 29/08**

(30) Priority: **22.06.90 GB 9013926**

(43) Date of publication of application:
**02.01.92 Bulletin  92/01**

(84) Designated Contracting States:
**DE FR IT**

(71) Applicant: **THE GENERAL ELECTRIC
COMPANY, p.l.c.
1 Stanhope Gate
London W1A 1EH(GB)**

(72) Inventor: **Lau, Dominic Wai-Fung
127 Andover Avenue, Alkrington, Middleton
Manchester, Lancashire M24 1JO(GB)**
Inventor: **Wilson, Simon Edward
9 Mills Hil Road
Middleston, Manchester M24 2EF(GB)**
Inventor: **Stocker, Jonathan David
2 Marsh Lea, Diggle
Saddleworth, Oldham 0L3 5LB(GB)**

(74) Representative: **Hoste, Colin Francis
The General Electric Company p.l.c. Central
Patent Department (Wembley Office) Hirst
Research Centre East Lane
Wembley, Middlesex HA9 7PP(GB)**

(54) **A vertical pnp transistor.**

(57) The invention relates to the fabrication of a high performance vertical PNP transistor inside a collector-diffused-isolation structure (12,15). A buried P+ layer (13) is used to extend the P type thin epitaxial layer (14) inside the CDI structure to enable the formation of a vertical PNP transistor. Transistors fabricated in this way will have high $F_T$ and low parasitic resistance, while at the same time possess the latch up immunity of the CDI structure.

Fig.2(h)

This invention relates to a vertical PNP transistor.

In the vertical transistor, current flow from the emitter to the collector is in the vertical direction. When the vertical PNP transistor is arranged such that an N type base is disposed on a P type collector and a P type emitter is placed over the base, the current flow from the emitter to the collector is in the vertical direction.

For high performance mixed digital and linear applications, NPN and PNP transistors should have high $F_T$, (unity gain band width of the transistor), low parasitic resistance and be fully isolated. High speed NPN transistor processes are readily available, for example the LG (FAB4) process, which is a 1.2um minimum feature size bipolar process. However, in this process there are no high performance PNP transistor. Other known PNP transistor processes produce mainly lateral PNP transistors which have low speed. The $F_T$ of these transistors are below 100 MHz. Other processes produce vertical PNP transistors which are not fully isolated. This puts severe restrictions on circuit applications.

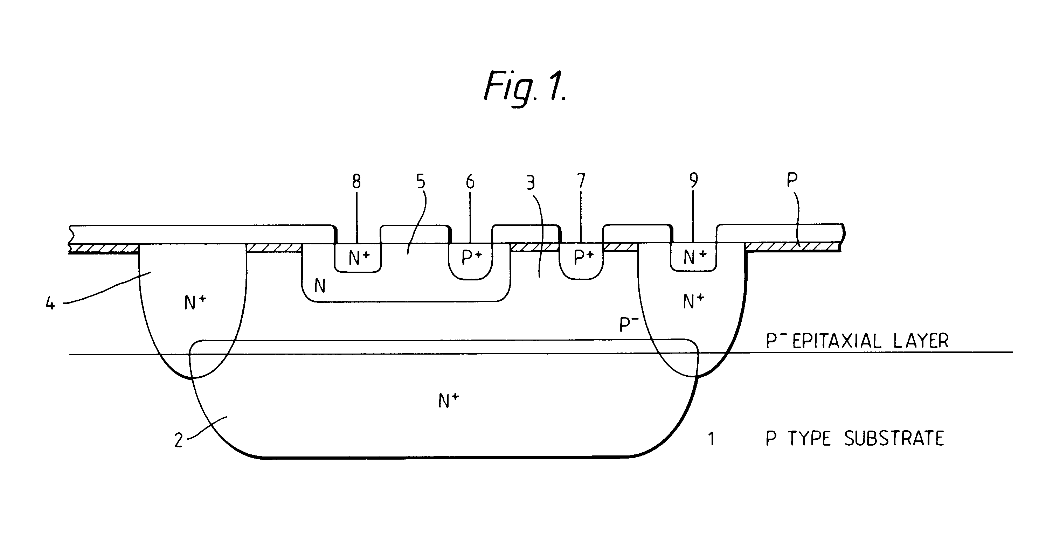

Fully isolated PNP transistors inside a collector diffused isolation (CDI) structure with $F_T$ as high as 300 MHz have been realised in the LD (FAB2) process which is a 2.5um minimum feature size complimentary bipolar process. A cross section of one of these transistors is shown in Figure 1. For a high speed process, a thin epitaxial layer is required. This enables vertical scaling and reduces transistor parasitic capacitance. Reducing the epitaxial layer thickness will improve the speed performance of NPN transistors but it will prevent the formation of a vertical PNP transistor inside the CDI structure. This is the case when a thin epitaxial layer of 1.2 microns is used in the LG (FAB4) process. The $F_T$ of the NPN transistors is improved to 6 GHz, but the vertical PNP transistor structure embodying this invention can not be fabricated in this thin epitaxial layer.

According to the invention there is provided a vertical PNP transistor including a region of P type epitaxial layer enclosed in an isolation structure of N+ type material, an N type base provided in said region of epitaxial layer, an emitter of P+ material formed on said base of N type material characterised by a buried layer of p+ type material adjoining said region of epitaxial layer in said isolation structure.

In this invention, this problem is overcome by putting the P+ layer on top of the buried N+ layer. This buried P+ layer converts part of the buried N+ layer into P type and at the same time pushes back the up diffusion of the buried N+ layer. Effectively, the thin P type epitaxial layer of about 1.2 microns is extended by the buried P+ layer to form a thicker overall P type layer for the formation of the vertial PNP transistor. The buried P+ layer also helps to reduce the collector resistance of the PNP transistor. Due to the thin epitaxial layer, all the junctions of the PNP transistor are very shallow. Typical emitter junction is less than 0.25um and the base width is about 0.1 micron. Therefore it is expected that the $F_T$ of such a PNP transistor will be in the gigahertz range.

In the course of realising such a transistor, the dopant concentration of the buried P+ layer has to be chosen very carefully. Too little dopant will cause collector pinch off and in the worse case no transistor action. Too high a dopant concentration will result in low collector/base breakdown and low collector/isolation breakdown voltage.

$BF_2$ implant at low energy is used for the P emitter. This is necessary to realise shallow emitter. However, sufficient high dose is necessary to achieve high emitter efficiency.

Base implant also requires careful optimisation to produce narrow base width and at the same time a reasonable sustaining voltage.

The present invention will now be described further by way of example with reference to the accompanying drawings, in which:-

Figure 1 is a cross section of a known PNP transistor in a collector diffused isolation structure; and

Figures 2(a) to 2(b) illustrate, schematically, steps in the method of fabrication of a vertical PNP transistor in a collector isolation structure according to the present invention; Figure 2(h) illustrates the vertical PNP transistor embodying the invention.

Figure 1 illustrates a known vertical PNP transistor fabricated by LD (FAB2) process. In this known transistor N+ type material slab 2 is provided on a P type substrate 1. A P- type epitaxial layer 3 is formed on the substrate 1 and an isolation structure 4 is provided to enclose a region of the epitaxial layer 3. An N type base 5 is formed on the eptiaxial layer 3 inside the isolation structure 4. An emitter 6 of P+ type material is formed in the base 5 and a collector contact 7 of P+ type material is formed in the epitaxial layer 3. A base contact 8 and an isolation contact 9, each of N+ type material, are formed respectively in the base 5 and the isolation structure 4.

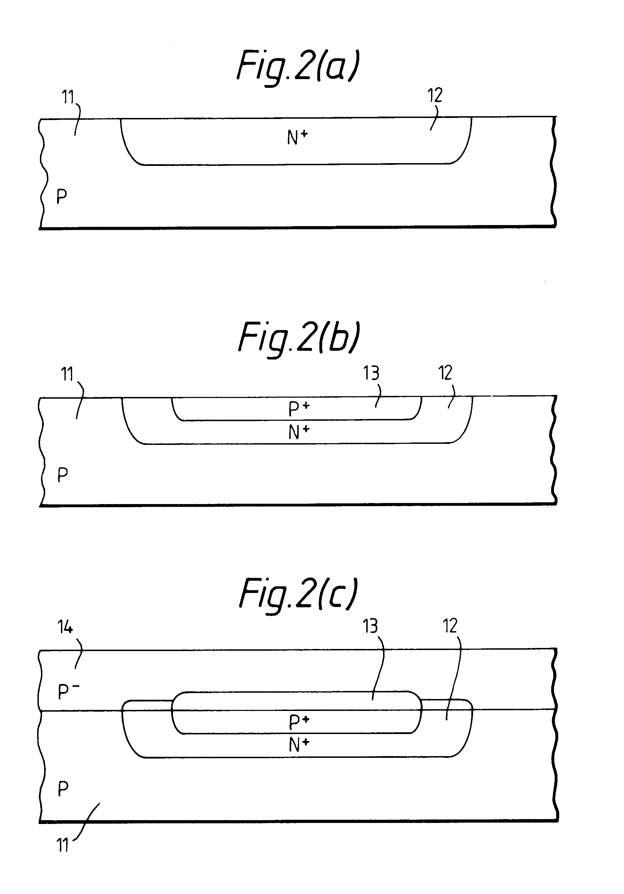

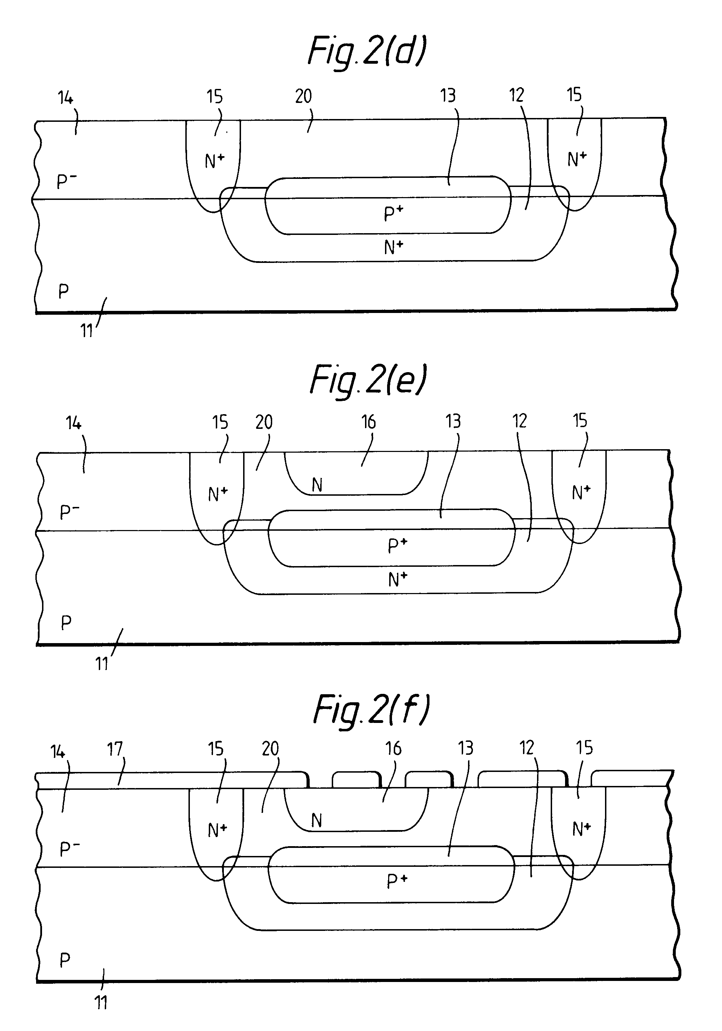

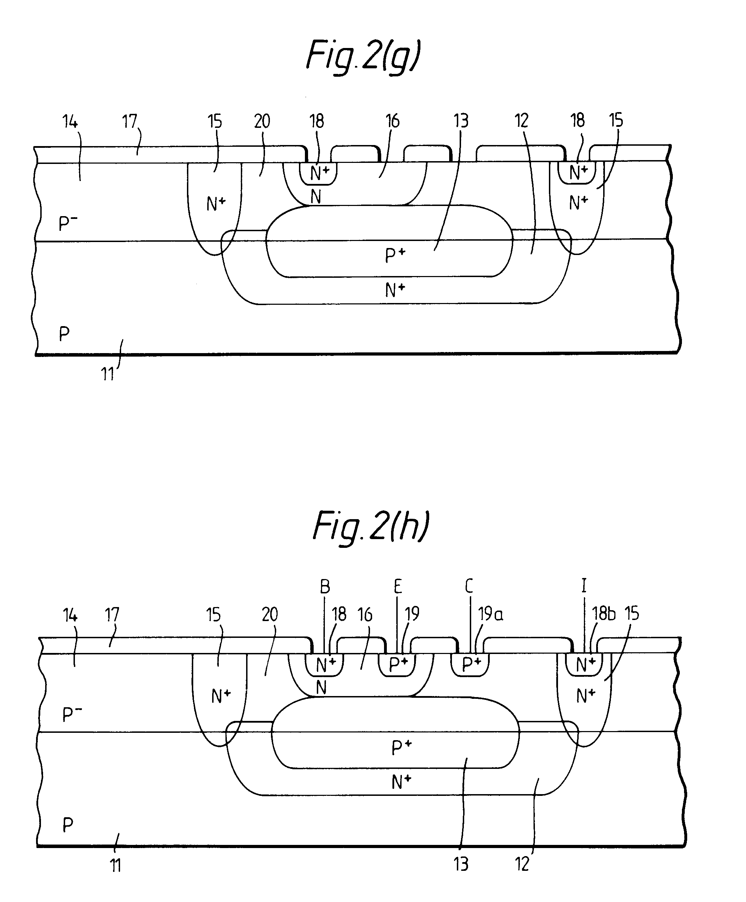

Referring to Figure 2(a), upon a P type substrate 11, an N+ type material slab 12 is formed, for example by gaseous diffusion or ion implantation.

In accordance with the invention, as illustrated in Figure 2(b) a P+ type material slab 13 is formed on top of the N+ type material slab 12 by gaseous diffusion or ion implantation.

A P type epitaxial layer 14 is deposited on the substrate 11 as illustrated in Figure 2(c). The up diffusion of the buried N+ layer 12 into the epitaxial layer 14 is compensated by the buried P+ layer 13. The buried P+ layer also inverts part of the buried N+ layer 12.

In Figure 2(d), an isolation volume 15 is doped to form an N+ type material enclosing a P type epitaxial volume 20.

An N type base area 16 is formed inside the collector diffused isolation structure by diffusion or ion implantation as illustrated in Figure 2(e).

An oxide or nitride layer 17 is then formed on the surface of layer 14. This is followed by the opening of apertures as illustrated in Figure 2(f) to allow subsequent contact to collector, emitter, base and also isolation area. This will allow the isolation regions to be independently biased.

In Figure 2(g), a base contact 18 and isolation contact 18a, each of N+ type material are then formed respectively in the base area 16 and isolation volume 15 by diffusion or ion implantation.

Finally, an emitter 19 amd collector contact 19a each of P+ type material are formed respectively in the base area 16 and P type epitaxial area 10 (Figure 2(h)).

## Claims

1. A vertical PNP transistor including a region of P type epitaxial layer (14) enclosed in an isolation structure (12,15) of N+ type material, an N type base (16) provided in said region of epitaxial layer (14), an emitter (19) of P+ material formed on said base (16) of N type material characterised by a buried layer (13) of P+ type material adjoining said region of epitaxial layer (14) in said isolation structure (12,15).

2. A transistor according to Claim 1, wherein said isolation structure is an N+ type material slab formed on a P type substrate and a wall of N+ type material extending upwardly from said slab to enclose said region of P type epitaxial layer, said P+ buried layer being formed on top of said N+ type material slab.

3. A transistor according to Claim 1 or Claim 2, including an oxide or nitride layer formed on the surface of said epitaxial layer, said oxide or nitride layer having openings in which said emitter and contacts for collector, base and isolation areas are provided.

4. A method of forming a vertical PNP transmitter, which comprises providing a region of P type epitaxial layer enclosed in an isolation structure of N+ type material, forming N type base on said region of epitaxial layer and forming an emitter of P+ material on said base of N type material characterised in that said method further comprises providing a buried layer of P+ type material adjoining said region of epitaxial layer.

5. A method according to Claim 1, wherein said buried layer of P+ type material is formed on N+ type material slab formed on a P type substrate, said epitaxial layer being formed on said buried layer of P+ type material.

6. A method according to Claim 5 further comprises forming an oxide or nitride layer on said epitaxial layer, forming a plurality of openings in said oxide or nitride layer and forming in said openings said emitter and contacts for said collector, said base and said isolation structure.

Fig. 1.

## Fig.2(a)

11    12

N⁺

P

## Fig.2(b)

11    13    12

P⁺
N⁺

P

## Fig.2(c)

14    13    12

P⁻

P⁺
N⁺

P

11

# Fig.2(d)

# Fig.2(e)

# Fig.2(f)

## Fig.2(g)

## Fig.2(h)

7

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 038 680  (I. TSUYUKI)<br>* figures 6A-6L; column 7, line 8 - column 9, line 54 *<br>– – – | 1-6 | H 01 L 29/08 |
| A | DE-A-2 553 151  (SONY)<br>* figures 10,12 *<br>– – – | 1-6 | |
| A | US-A-4 160 990  (J. KANE)<br>* figures *<br>– – – – – | 1-6 | |

| | | | TECHNICAL FIELDS SEARCHED (Int. Cl.5) |
|---|---|---|---|
| | | | H 01 L |

The present search report has been drawn up for all claims

| Place of search | Date of completion of search | Examiner |
|---|---|---|
| Berlin | 20 August 91 | JUHL A. |

CATEGORY OF CITED DOCUMENTS

X : particularly relevant if taken alone
Y : particularly relevant if combined with another
document of the same catagory
A : technological background
O : non-written disclosure
P : intermediate document
T : theory or principle underlying the invention

E : earlier patent document, but published on, or after
the filing date
D : document cited in the application
L : document cited for other reasons

 

& : member of the same patent family, corresponding
document